(19)

Europäisches
Patentamt
European
Patent Office
Office européen
des brevets

(11)     EP 2 261 947 A1

(12)     EUROPEAN PATENT APPLICATION
published in accordance with Art. 153(4) EPC

(43) Date of publication:
   **15.12.2010 Bulletin 2010/50**

(21) Application number: **09728554.8**

(22) Date of filing: **03.04.2009**

(51) Int Cl.:
*H01J 37/22* (2006.01)      *H01J 37/26* (2006.01)
*H01J 37/295* (2006.01)

(86) International application number:
**PCT/JP2009/056960**

(87) International publication number:
**WO 2009/123311 (08.10.2009 Gazette 2009/41)**

(84) Designated Contracting States:
   **AT BE BG CH CY CZ DE DK EE ES FI FR GB GR HR HU IE IS IT LI LT LU LV MC MK MT NL NO PL PT RO SE SI SK TR**
   Designated Extension States:
   **AL BA RS**

(30) Priority: **04.04.2008   JP 2008098562**

(71) Applicants:
• **Hitachi, Ltd.**
   **Chiyoda-ku**
   **Tokyo 100-8280 (JP)**
• **National University Corporation**
   **Hokkaido University**
   **Sapporo-shi**
   **Hokkaido 060-0808 (JP)**

(72) Inventors:
• **DOBASHI, Takashi**
   **Tokyo 100 8220 (JP)**
• **KOGUCHI, Masanari**
   **Tokyo 100-8220 (JP)**
• **KAMIMURA, Osamu**
   **Tokyo 100-8220 (JP)**
• **OHTA, Hiroya**
   **Tokyo 100-8220 (JP)**
• **GOHARA, Kazutoshi**
   **Hokkaido 060-8628 (JP)**

(74) Representative: **Strehl Schübel-Hopf & Partner**
   **Maximilianstrasse 54**
   **80538 München (DE)**

(54)     **DIFFRACTION IMAGE CAPTURING METHOD AND CHARGED PARTICLE BEAM DEVICE**

(57)     A charged particle beam microscope device of the present invention is configured such that in a diffraction pattern obtained by radiating a parallel charged particle beam onto a sample (22) having a known structure, a distance (r) between spots of a diffraction pattern, which reflects the structure of the sample, is measured, and the variation of a distance (L) between the sample and a detector, which depends on a diffraction angle (θ), is corrected. This enables the correction of distortion that varies with an off-axis distance from the optical axis in a diffraction pattern, and a high precision structural analysis by performing accurately analyzing the spot positions of the diffraction pattern.

FIG. 1

EP 2 261 947 A1

**Description**

Technical Field

The present invention relates to a diffraction pattern capturing method and a charged particle beam device, and particularly, for example, to a method of capturing a diffraction pattern and a charged particle beam device, in which a charged particle beam is radiated into a sample, and a charged particle beam occurring from the sample is detected thereby capturing a diffraction pattern of the sample.

Background Art

As a method of observing a diffraction pattern for the analysis of crystal structure by using an electron beam, there are a TED (Transmission Electron Diffraction), an LEED (Low Energy Electron Diffraction), and a RHEED (Reflected High Energy Electron Diffraction) methods, etc. Among those, while the LEED and RHEED methods both observe the reflection of an electron beam launched to the surface of a sample, the TED method observes an electron beam that has transmitted through the inside of a sample.

Therefore, the configuration of a TED device resembles that of a TEM (Transmission Electron Microscope), and both are often used in combination. Moreover, the TEM is a device in which a parallel electron beam is radiated into a sample and electrons that have transmitted through the sample are observed by being projected to a detector such as a fluorescent screen, a camera, a film, an imaging plate, and the like by an electromagnetic lens.

In general, the resolution of a TEM which accelerates electrons at 200 kV is supposed to be about 100 times worse than 0.025 angstrom which is the original wavelength of the electron beam. It is known that the main cause of this is due to the effect of an aberration intrinsically included in a lens. Examples of the aberration that affects the resolution include a spherical aberration, a chromatic aberration, a coma aberration, astigmatism, a field curvature, and a diffraction aberration. One method of avoiding the resolution decrease of the resolution of electron microscope due to such aberrations is a phase retrieval method.

In a phase retrieval method, a real image is reconstructed by using a diffraction pattern of an object. Therefore, it is necessary to acquire a more correct diffraction pattern. However, a diffraction pattern generally produces deformations due to a field curvature caused by a flat detector plane, due to a distortion, and due to the external environment of the device. Accordingly, the correction of deformation becomes necessary to reconstruct (recover) a real image at a high precision.

On the other hand, correction of the position of diffraction spot has been performed so far in crystal structure analyses. However, since in a phase retrieval method, information of the entire diffraction pattern plane is required, correction over the entire diffraction pattern is needed. Moreover, detectors of electron microscopes often have a plane configuration and therefore a problem that correction for field curvature of the diffraction pattern plane is not sufficient. A diffraction spot at a higher order diffraction spot has a larger distortion compared to one at a lower order diffraction spot, for example a distortion of 32.5 micrometers on a detector at a portion 25 mm away from the central beam with the camera length being 0.4 m. Therefore, regarding the solution of field curvature of the diffraction pattern plane due to the plane configuration of a detector, Patent Document 1 proposes a detector having a spherical surface along the Ewald sphere.

Patent Document 1: International Patent Publication WO 2005/114693A1

Disclosure of the Invention

Problems to be Solved by the Invention

However, since in the detector having a spherical surface of Patent Document 1, the curvature of the spherical surface is fixed, the camera length L cannot be varied. Therefore,

Patent Document 1 cannot realize observations by various observation conditions.

Moreover, aside from the field curvature of diffraction pattern plate, lenses used in electron microscopes have a problem of distortion which varies depending on an off-axis distance from the optical axis. Further, there also may be a problem that the diffraction pattern is distorted due to an external environment such as a magnetic field of an ion pump, and the like.

The present invention has been made in view of such circumstances, and provides a method of capturing a diffraction pattern, which can solve the problems of field curvature and/or a distortion which occurs in a diffraction pattern.

Means for Solving the Problems

To solve the above described problems, the present invention captures a diffraction pattern of a sample by radiating a charged particle beam onto the sample and detecting the charged particle beam occurring from the sample. Since a diffraction pattern includes field curvature and a distortion (both of which are collectively referred to as a distortion) of the diffraction pattern plane, it is not possible without correcting them to reconstruct an accurate real image form the diffraction pattern. Therefore, in the present invention, first, a diffraction pattern of a first sample (for example, a sample having a known structure) under a predetermined measurement condition to measure the distortion of the diffraction pattern in the first sample. Then, a correction parameter for correcting the distortion of the diffraction pattern in the first sample is calculated. On the other hand, a diffraction pattern of a second sample (for example, a sample having an unknown structure) is captured under the same predetermined measurement condition to correct the distortion of the diffraction pattern of the second sample by using the correction parameter in the first sample.

When the distortion of a diffraction pattern is field curvature of the image plane of the diffraction pattern, a parameter for correcting the field curvature of the image plane is calculated based on a diffraction angle and a camera length (for example, by using below described Equation (1)).

When the deformation of the diffraction pattern is a distortion, the difference between the diffraction pattern obtained from the structure of the first sample and the diffraction pattern in which a deformation coefficient is taken into consideration is determined, and fitting of distortion coefficients to minimize the difference is performed (for example, using below described Equation (3)). A distortion amount is calculated by using the distortion coefficients obtained by performing the fitting, and is taken as a correction amount for correcting the distortion. Then, the correction amount for correcting these distortion coefficients and the distortion is taken as a correction parameter.

Moreover, when the distortion of a diffraction pattern is a distortion, a distortion vector between the diffraction pattern obtained from the structure of the first sample and a distorted diffraction pattern of the first sample may be calculated so that the distortion vector is taken as a correction parameter.

Further characteristic features of the present invention will become apparent from the below described best modes for carrying out the invention and the appended drawings.

Advantages of the Invention

According to the present invention, it becomes possible to correct the distortion (field curvature and/or a distortion occurred in a diffraction pattern plate) of a captured diffraction pattern, thereby enabling the accurate analysis of the structure of an unknown sample from a high precision analysis of a diffraction pattern.

Brief Description of the Drawings

Figure 1 is a diagram showing a schematic configuration of an electron microscope according to an embodiment of the present invention.

Figure 2 is a flow diagram to illustrate the processing for performing the correction of a distortion by using a pixel detector from a TEM diffraction pattern.

Figure 3 is a diagram to illustrate field curvature of a diffraction pattern plane.

Figure 4 is a diagram to illustrate a method of correcting the field curvature of the diffraction pattern plane.

Figure 5 is a diagram to illustrate a distortion.

Figure 6 is a diagram to illustrate a method of performing the correction of a distortion by using a center point of the distortion.

Figure 7 is a diagram to illustrate a method of correcting a distortion by using a plurality of (two) center points of distortion.

Figure 8 is a diagram to illustrate a method of creating a distortion map.

Figure 9 is a diagram showing an example of an operating screen to correct field curvature of a diffraction pattern plane.

Figure 10 is a diagram showing an example of an operating screen to correct a distortion by using fitting.

Figure 11 is a diagram showing an example of an operating screen to correct a distortion by using a distortion map.

Figure 12 is a diagram showing an example of an operating screen to perform the correction of a distortion for any sample.

Description of Symbols

11: electronic gun, 12: irradiation lens, 13: condenser aperture, 14: misalignment correction deflector, 15: stigma correction lens, 16: image shifting deflector, 17: object lens, 18: intermediate lens, 19: projection lens, 20: imaging plate, 21: CCD camera, 22: sample, 23: sample stage, 24: electron gun control circuit, 25: irradiation lens control circuit, 26: condenser aperture control circuit, 27: misalignment correction deflector control circuit, 28: stigma correction lens control circuit, 29: image shifting deflector control circuit, 30: object lens control circuit, 31: intermediate lens control circuit, 32: projection lens control circuit, 33: camera chamber control circuit, 34: CCD camera control circuit, 35: sample stage control circuit, 36: computer, 50: irradiation electron beam, 51: sample, 52: electron beam detector, 54: electron beam irradiation position, 55: direct beam spot, 61: sample, 62: electron beam detector, 64: direct beam spot, 65: diffraction spot, 66: distance, 70: diffraction pattern without distortion, 73: diffraction pattern with distortion, 80: diffraction pattern with distortion, 81: deformation center, 82: distance between diffraction spots, 83: diffraction pattern without distortion, 84: diffraction spot with distortion, 85: diffraction spot without distortion, 86: electron beam detector, 87: distance from deformation center, 90: first deformation center, 91: second deformation center, 100: diffraction spot of diffraction pattern with distortion, 101: diffraction spot of diffraction pattern without distortion, 102: magnitude of distortion, 110: pre-correction diffraction pattern, 111: post-correction diffraction pattern, 112: camera-length calculation result display region, 113: direct beam spot coordinates display region, 115: correction button, 116: display region of camera length calculation error, 117: a field curvature correction operating screen example of diffraction pattern plane, 119: lens current display region, 120: next button, 121: display of stage position by digital controlling value, 130: pre-distortion-correction diffraction pattern display region, 131: post-distortion-correction diffraction pattern display region, 132: distortion coefficient display region, 133: deformation center coordinates display region, 134: magnification factor/rotation display region, 135: data save button, 136: fitting error display region, 137: distortion correction operating screen, 138: data display region, 139: lens current display region, 140: operating screen example of correction using distortion map, 141: pre-correction diffraction pattern display region, 142: distortion map display region, 143: diffraction spot of diffraction pattern with distortion, 144: diffraction spot of diffraction pattern without distortion, 145: micromotion of corresponding spot, 146: correction function pulldown menu, 147: lens current display region, 148: display of stage position by digital controlling value, 149: data save button, 150: operating screen example of distortion correction for arbitrary sample, 151: pre-correction diffraction pattern display region, 152: post-correction diffraction pattern display region, 153: distortion file selection pulldown menu, 154: calculation start button, 155: save button.

Best Mode for Carrying Out the Invention

The present invention is for the purpose of calculating a correction amount for correcting a distortion of a diffraction pattern (a concept including field curvature and a distortion of the diffraction pattern plane) captured from a known sample and applying that to an unknown sample to more accurately capture a diffraction pattern of the unknown sample.

Hereafter, an embodiment of the present invention will be described with reference to appended drawings. However, it is to be noted that the present embodiment is only an example for implementing the present invention, and will not limit the technical scope of the present invention. Moreover, a common configuration in each figure is given the same reference number. It is noted that in the present embodiment, a TEM is used as the system for capturing a diffraction pattern.

<Configuration of TEM>

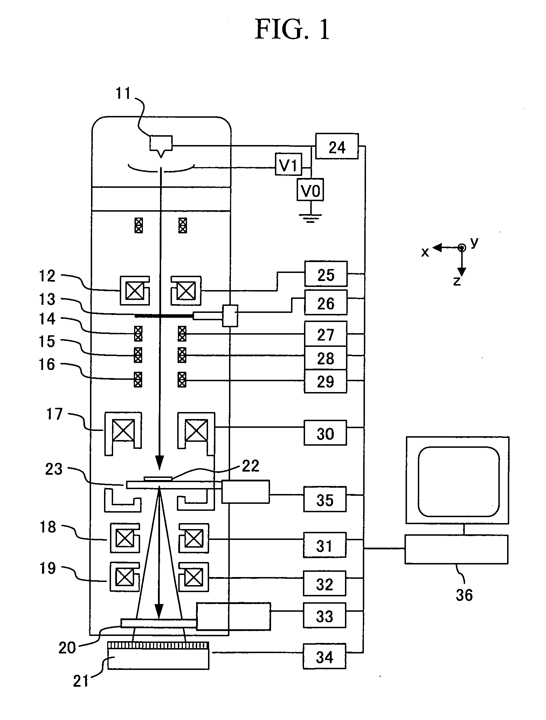

The present embodiment relates to a technique for correcting a diffraction pattern obtained by a TEM, and Figure 1 is a diagram showing a schematic configuration of the TEM according to the present embodiment.

In Figure 1, an electron beam emitted from an electron gun 11 is demagnified by a first and second condenser lenses 12, with its radiation angle being limited by a condenser aperture 13, and is radiated in parallel into a sample 22 by an anterior magnetic field of an object lens 17 through an axis alignment at a misalignment correction deflector 14, a stigma correction lens 15, and an image shifting deflector 16. The sample 22 is held by a sample stage 23. The electron beam radiated into the sample is divided into a part that passes therethrough and a part that is diffracted thereat. Letting a lattice constant be d, and the wavelength of the electron beam be $\lambda$, the electron beam is diffracted into a direction in which the Bragg condition $2d \times \sin\theta = n\lambda$ (n = 1, 2, ...) holds. At a position sufficiently away from the sample, a diffraction pattern can be captured without using a lens, and the distance from the sample to the detection plane is referred to a camera length. Generally, in a TEM, due to the effect of a posterior magnetic field of an object lens 17, a diffraction pattern is formed at a back focal plane, which is located between the object lens 17 and an intermediate lens 18, and is enlarged by the intermediate lens 18 and a projection lens 19 to be detected by an imaging plate, a film 20, or a CCD camera 21. The camera length in this case is defined by converting the obtained diffraction pattern into a case in which the diffraction pattern is obtained without the lens. The device control is performed by an electron gun control circuit 24, an irradiation lens control circuit 25, a condenser aperture control circuit 26, a misalignment correction deflector control circuit 27, a Stig meter control circuit 28, an image shifting deflector control circuit 29, an object lens control circuit 30, an intermediate lens control circuit 31, a projection lens control circuit 32, a camera chamber control circuit 33, a CCD camera control circuit 34, a sample stage control circuit 35, and has a function of creating any electro-optic conditions (measurement conditions) by taking the value of each control part into a computer 36 through the control circuits and transmitting each value from the computer 36 through the control circuits.

<Outline of distortion correction processing of diffraction pattern>

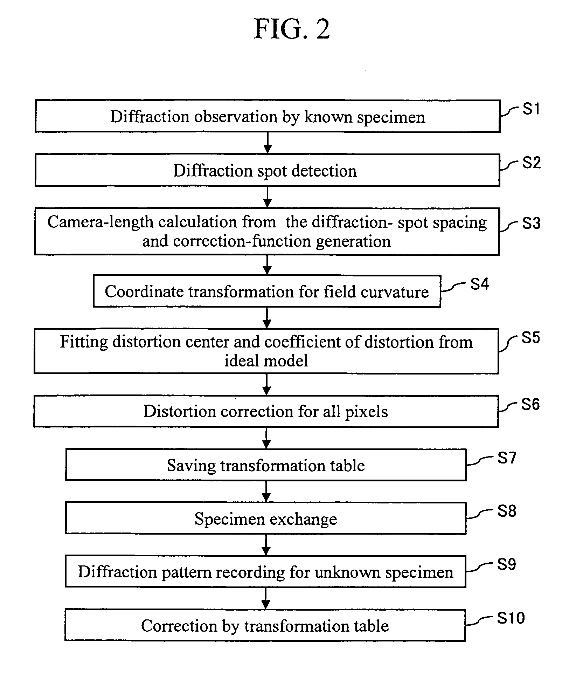

Next, distortion correction processing of a diffraction pattern will be described. Figure 2 is a flow diagram to illustrate diffraction pattern correction processing when a TEM is used. The present invention makes it possible to obtain a diffraction pattern without a distortion due to field curvature and a distortion of the diffraction pattern plane for any sample by actually capturing a diffraction pattern for a known sample having a known structure and saving the difference from an original diffraction spot as a correction parameter.

At step S1, a sample having a known structure is set in the sample stage of an electron microscope, an electron beam is let in, and a diffraction pattern is picked up so that a processing part of the computer 36 captures the diffraction pattern. The captured diffraction pattern is saved in a memory, which is not shown, of the computer 36. At step S2, the processing part detects the positions (coordinates) of a direct beam spot and a diffraction spot on the detector.

At step S3, the above described processing part derives a correction function for deriving a camera length and correcting field curvature of the diffraction pattern plane, from obtained coordinate position. Next, at step S4, the above described processing part performs the correction relating to the field curvature of the diffraction pattern plane. Then, the process moves to a step of correcting the distortion by performing an analysis on the diffraction pattern in which the field curvature of the diffraction pattern plane is corrected.

Then, at step S5, the above described processing part prepares an ideal diffraction pattern, which is conceived from a known sample, in a computer as an ideal system, and introduces distortion into the diffraction pattern thereby reproducing the diffraction pattern obtained at step S4. As a result of this, a distortion coefficient can be determined. Moreover, at step S6, the above described processing part converts the diffraction pattern obtained at step S4 into a state without distortion, by using the distortion coefficient determined at step S5. That is, the correction of distortion is performed. At step S7, a field curvature correction and a distortion correction coefficients of diffraction pattern plane is saved in a memory which is not shown.

At step S8, the known sample is replaced with a sample having an unknown structure (any sample) thereby preparing for capturing a diffraction pattern of the unknown sample. Then, at step S9, after a diffraction pattern of any sample is captured, a field curvature correction and distortion correction of the diffraction pattern plane are performed, and at step S10, the above described processing part performs the distortion correction of the diffraction pattern of any sample by using the saved a field curvature correction and distortion correction coefficients.

It is noted that, in the following, the field curvature correction and distortion correction of an image plane will be described in detail.

<Field curvature correction of diffraction pattern plane>

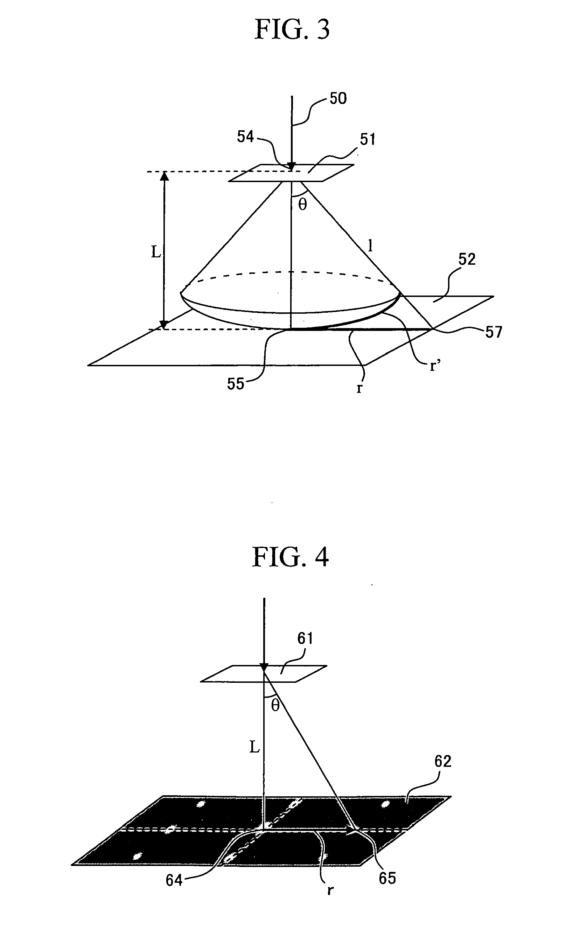

First, by using Figure 3, description will be made on how field curvature of a diffraction pattern plane occurs and why correction thereof needs to be performed. When an incoming electron beam 50 is launched into a sample 51, a diffraction spot appears. At that moment, it is known that the diffraction pattern plane is at an equal distance from an electron beam irradiation position 54. However, since the electron beam detector 52 generally has a plane configuration, a deviation, which is dependent on the diffraction angle θ, will occur between the diffraction pattern plane and the detection plane. Letting r be the distance between a spot 55 formed by the transmitted electron beam and a spot 57 which is formed by the electron beam which is diffracted at an angle θ, Equation (1) will be obtained with the distance to be corrected being r' and the camera length being L.

[Expression 1]

$$r' = L \arctan\left(\frac{r}{L}\right) \qquad (1)$$

If the electron beam detector 52 has a plane configuration, a problem may arise in performing the measurement of distortion in a phase retrieval method which utilizes the position of the spot in a diffraction pattern as information. Therefore, correction of the field curvature of diffraction pattern plane by Equation (1) is necessary.

A specific method of correcting the field curvature of a diffraction pattern plane will be described by using Figure 4. The method of correcting the field curvature of the diffraction pattern plane is a method of preparing a sample 61 having a known structure and capturing a diffraction pattern thereof. The distance r between a spot 64 formed by the electron beam that has transmitted through the sample and a spot 65 formed by the electron beam that is diffracted at a diffraction angle θ is measured from a diffraction pattern. It is known that the distance L between the sample 61 and a detector 62 is given by Equation (2).

[Expression 2]

$$\tan\theta = \frac{r}{L} \qquad (2)$$

The angle θ can be determined from the fact that the lattice constant d of the sample 61 and the wavelength λ of the incoming electron beam are known. Therefore, by measuring the distance r, the distance L between the sample 61 and the detector 62 can be determined. Then, by using Equation (1), it becomes possible to correct the field curvature of the diffraction pattern plane. That is, the field curvature of the image is corrected by moving the obtained diffraction pattern by the amount of r - r'.

<Distortion correction of diffraction pattern>

There are a plurality of methods for correcting the distortion of a diffraction pattern. Among those, three methods will be shown by way of example below.

(1) Method 1

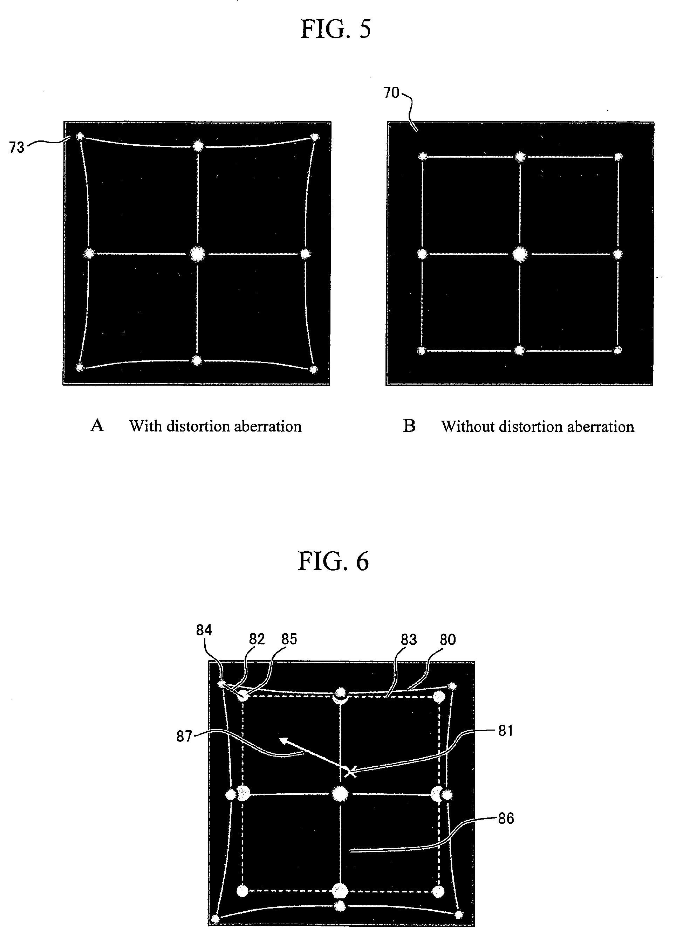

Next, the need of performing the correction of the distortion of a diffraction pattern when a TEM is utilized will be described. Figure 5 shows an example of the comparison between a diffraction pattern 73 with distortion and a diffraction pattern 70 without distortion of a known sample. Since the lens magnification factor varies with an off-axis distance from the optical axis thereof, use of an electromagnetic lens involves a distortion due to distortion. Moreover, the distortion may include a distortion associated with external environment. The external environment includes a dissymmetric magnetic field and a dissymmetric electric field. A distortion due to distortion and a distortion associated with external environment may become a serious problem for the application of a phase retrieval method for reconstructing a real image based on a diffraction pattern. Therefore, the correction of these distortions becomes necessary.

Next, an example of the method of measuring a distortion will be described by using Figure 6. A sample having a known structure will be used for the measurement of distortion. Here, a distortion amount Dr is defined as shown by Equation (3), with a distance 87 from the deformation center (any point) 81 being r.

[Expression 3]

$$\Delta r = C_3 r^3 + C_2 r^2 + C_1 r + C_0 \qquad (3)$$

A fitting is performed (for example, by using the least square method) on a diffraction pattern 80 including distortion, which has been experimentally captured from a diffraction pattern 83 determined from the structure of a known sample, with a deformation center 81 and distortion coefficients $C_3$, $C_2$, $C_1$, and $C_0$ as parameters. In doing so, the distortion coefficients and the deformation center which minimize the distance 82 between corresponding diffraction spots such as a diffraction spot 85 of the diffraction pattern 83 and a diffraction spot 84 of a diffraction pattern 80 are determined. Therefore, the distortion coefficients and the deformation center can be measured from a diffraction pattern.

To correct the distortion of a diffraction pattern of any sample, after deformation center coordinates and distortion coefficients are determined by using Equation (3) in a known sample, a diffraction pattern of any sample (unknown sample) is captured at the same electro-optic condition. The same electro-optic condition refers to a lens current value of each part which is obtained when a diffraction pattern of a known sample is captured. The lens current value of each part is stored in a computer when a diffraction pattern of a known sample is captured. Then, in capturing a diffraction pattern of any sample, a lens current value is sent to the device from the computer side so that the same electro-optic condition is realized. As a result of that, a diffraction pattern of any sample is captured under the obtained electro-optic condition, and correction is performed by using the deformation center coordinates and the distortion coefficients which have been already obtained. To be specific, upon determination of the distortion coefficients and the deformation center, the amount of distortion on any point on an electron beam detector 86 of Figure 6 becomes known. Therefore, determining a distortion amount $\Delta r$ by using the distance r from the deformation center 81 at any point on the detector, and letting the distance of the point after correction from the center 81 be R, the effect of distortion can be removed by adjusting such that R = r - $\Delta r$.

(2) Method 2

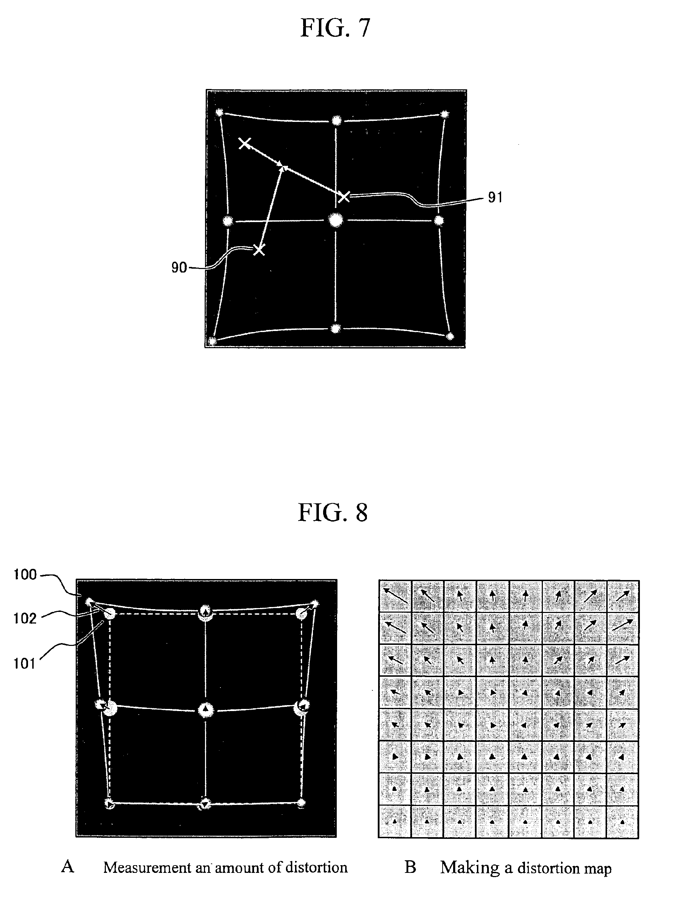

In the above described method 1, a method of determining distortion coefficients and a deformation center for obtaining a diffraction pattern similar to that of the known sample by setting only one center point has been described.
The method 2 provides a method of assuming a plurality of deformation centers in a diffraction pattern for more accurately measuring the amount of distortion. Accordingly, here, a case in which there are two deformation centers is described by using Figure 7.
Assuming two deformation centers: a first deformation center 90 and a second deformation center 91, and letting the distance from each center to a measuring point be $r_1$ and $r_2$, the distortion amount is defined by Equations (4) and (5). Then, by performing a fitting on a diffraction pattern with distortion, which is experimentally captured from a diffraction pattern without distortion of the known sample, with the two deformation centers and distortion coefficients $C_{31}$, $C_{32}$, $C_{21}$, $C_{22}$, $C_{11}$, $C_{12}$, $C_{01}$, and $C_{02}$ as parameters, it becomes possible to measure the amount of distortion more accurately than the case of one deformation center.

[Expression 4]

$$\Delta r_1 = C_{31}r_1^{\ 3} + C_{21}r_1^{\ 2} + C_{11}r_1 + C_{01} \qquad (4)$$

[Expression 5]

$$\Delta r_2 = C_{32}r_2^{\ 3} + C_{22}r_2^{\ 2} + C_{12}r_2 + C_{02} \qquad (5)$$

(3) Method 3

Moreover, another method for correcting the distortion of a diffraction pattern will be described. First, a diffraction pattern of a known sample is captured. Figure 8A shows a diagram in which a diffraction pattern with distortion is superposed with a diffraction pattern without distortion which is determined from the structure of a known sample. The diffraction pattern of the known sample can be known from the lattice constant d, the wavelength $\lambda$ of the incoming electron beam, and the camera length L during image pickup. The distance 102 between a diffraction spot 100 of a diffraction pattern with distortion and a diffraction spot 101 of a diffraction pattern without distortion is determined as a distortion vector relating to each diffraction spot. The distance 102 is determined two dimensionally as a distortion vector in accordance with the direction of pixel. Then, by subtracting each distortion vector from each diffraction spot position of a diffraction pattern with distortion, a diffraction pattern without distortion can be obtained.
Moreover, to perform correction for all the pixels, a discrete distortion vector determined from each diffraction spot is divided into each pixel unit. An example of such method is a method of using the least square method by use of a first order function as the fitting function. As the fitting function, a polynomial function, an exponential function, a logarithmic function, a trigonometric function, a hyperbolic function, and combinations thereof are conceived. By finely dividing the distortion vector into a pixel unit, Figure 8B is obtained. As a result of this, distortion in a diffraction pattern of the known sample can be determined, and by taking the difference of these distortion amounts from a distorted diffraction pattern, it becomes possible to obtain a diffraction pattern with less distortion.

<Operating screen for correction>

(1) Operating screen for a field curvature correction

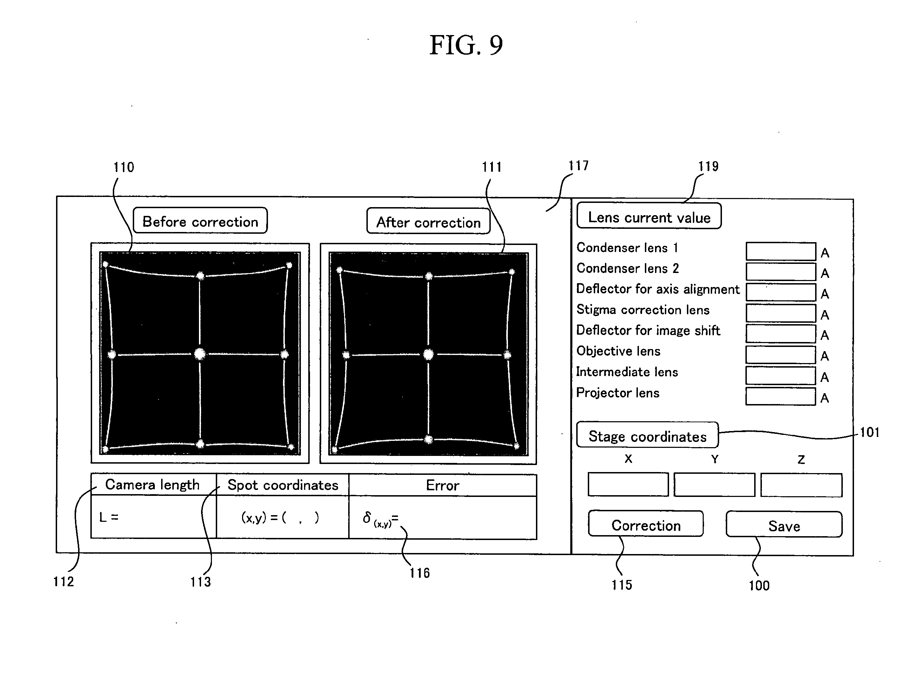

Next, an operating example of an operating screen (GUI) when correcting the field curvature of a diffraction pattern plane will be described. Figure 9 shows a field curvature correction operating screen example 117 of a diffraction pattern plane when correcting the field curvature of a diffraction pattern plane. On the display screen 117 of the computer 36, diffraction pattern data captured by the CCD camera 21 is displayed as a pre-correction diffraction pattern 110 and a post-correction diffraction pattern 111. The parameters used for correction are, respectively, displayed on a camera-length calculation result display region 112, a direct beam spot coordinates display region 113, a fitting error display region 116 of a direct beam spot, and a current value display region 119 of the electro-optic system in which the above described data is captured.

After capturing a pre-correction diffraction pattern 110, a user visually inspects the pre-correction diffraction pattern 110 and can decide whether or not to perform the correction, on a field curvature correction button 115 of diffraction pattern plane. Upon pressing the field curvature correction button of diffraction pattern plane, the above described a field curvature correction calculation is automatically performed. A correction value obtained by the correction calculation, a current value of the electro-optic system, and a voltage of the motor that controls the stage, or a digital control value relating to the stage position are displayed on each display region of the display screen 117. Moreover, it is configured that the user can confirm the correctness of the fitting error of direct beam spot and the calculation result of camera length.

Moreover, a pre-correction diffraction pattern 110, a post-correction diffraction pattern 111, an electro-optical system current value 119 which is captured from the main body side when a diffraction pattern is captured, and a digital control value 101 relating to the stage position can be saved in a memory within the computer 36 by a user pressing a save button 110. It is noted that they may be automatically saved in a memory within the computer 36 after the correction calculation.

(2) Operating screen for distortion correction in diffraction pattern

Next, an operation example of an operating screen (GUI) for distortion correction in a diffraction pattern will be described. A distortion coefficient and a deformation center, which are obtained by the measurement using a known sample, will have varied when the condition of the electro-optical system is changed. Therefore, it is necessary to capture a diffraction pattern of any sample without changing the condition of the electro-optical system. If the condition of the electro-optical system is kept unchanged, it is possible to perform the correction of distortion in a diffraction pattern for any diffraction pattern by using the distortion coefficients and the deformation center, which are determined in a known sample.

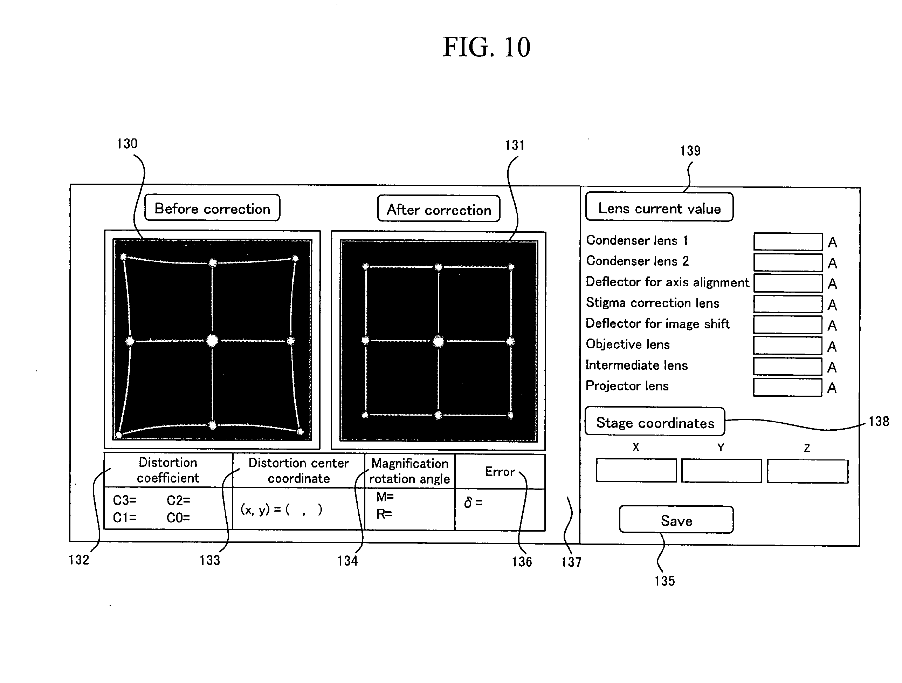

Figure 10 shows a concrete example of a distortion correction operating screen. A distortion correction operating screen 137 includes two image regions: a pre-distortion-correction diffraction pattern region 130 and a post-distortion-correction diffraction pattern region 131. Moreover, the distortion correction operating screen 137 has a distortion coefficient display region 132 and a deformation center coordinates display region 133, a region 134 for displaying a magnification factor and a rotation angle used for fitting a diffraction pattern obtained from the structure of a known sample to a diffraction pattern that is experimentally obtained, and a fitting error display region 136. It is noted that regarding a distortion coefficient (region 132) and deformation center coordinates (region 133), upon performing fitting for one or more deformation centers, each distortion coefficient and deformation center coordinates for distortion will be displayed.

The configuration is made such that pressing a save button 135 of Figure 10 will cause a pre-distortion-correction diffraction pattern, a post-distortion-correction diffraction pattern, an electro-optical system current value which is captured from the main body side when a diffraction pattern is captured, and a stage position to be saved in a memory within a computer.

Regarding the display procedure of results, other examples may also be conceived. For example, when the imaging plate film 20 of Figure 1 is used, the processing part of the computer 36 records the current value of the electro-optical system and the stage position for each photograph in synchronous with the operation of a camera chamber driving control part 33. In this occasion, by synchronizing the serial number given to the imaging plate film 20 with the number of saved data, it is possible to facilitate the saving of experimental conditions. The imaging plate film 20 is taken into the computer 36 after an experiment, the measurement and the saving of distortion in the above described method becomes possible.

(3) Operating screen for the correction of distortion due to external environment

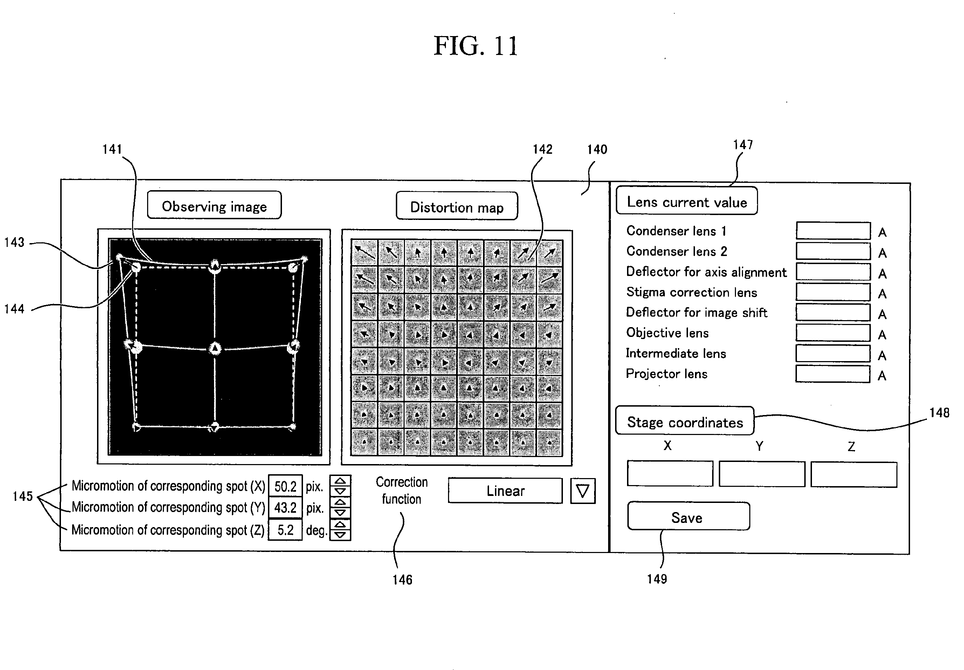

Figure 11 is a diagram showing a concrete example of the operating screen for distortion due to external environment. The screen 140 of the computer 36 includes a pre-correction diffraction pattern display region 141 for displaying a pre-correction diffraction pattern, and a distortion map display region 142 for displaying distortion in a map format, regarding diffraction pattern data captured by a CCD camera.

Moreover, a diffraction spot 143 of a diffraction pattern including distortion is superposed with the position of a diffraction spot 144 which is determined from a sample having a known structure, to confirm the corresponding position in the diffraction pattern. It is noted that the diffraction spot 144 which is determined from a sample having a known structure on a device screen can be superposed on the diffraction spot 143 of a diffraction pattern including distortion by using corresponding spot micromotion 145.

Moreover, a fitting correction function after the determination of a distortion vector between corresponding spots can be selected by a correction function pulldown menu 146. Then, an electronic optical system current value 147 which is captured from the main body side when a diffraction pattern is captured, and a stage position 148 are saved in a memory within the computer 36. Moreover, the condition to cause a distortion map 142 to be displayed is saved by the pressing of a save button 149.

(4) Operating screen for distortion correction of any sample

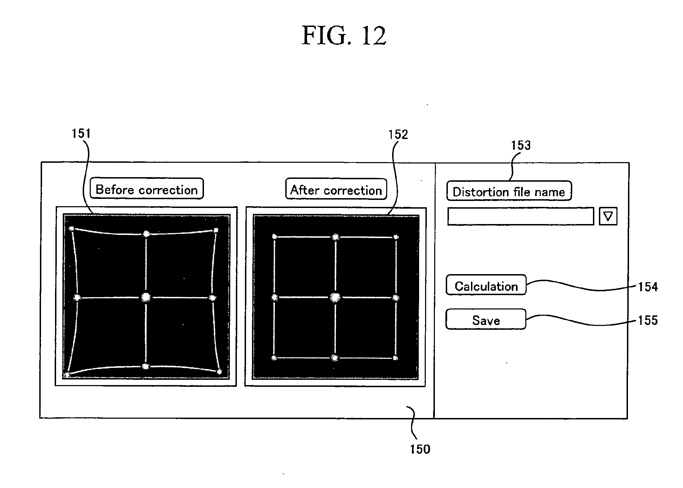

Figure 12 is a diagram showing a concrete example of the operating screen for performing distortion correction for any sample. In an operating screen 150 of Figure 12, a pre-distortion-correction diffraction pattern 151 and a post-distortion-correction diffraction pattern 152 are displayed. A user selects a file in which the measurement of distortion is performed in a known sample from a distortion file-name pulldown menu 153. Moreover, a post-distortion-correction diffraction pattern 152 in which correction is performed for the diffraction pattern for any sample is displayed on the screen 150 by a user pressing a calculation button 154. The user confirms the diffraction pattern displayed and thereafter can save the diffraction pattern of which distortion is corrected in a memory of the computer 36 by pressing a save button 155.

<Summary of embodiment>

As so far described, in the embodiment of the present invention, a diffraction pattern is captured, which is suitable for correcting field curvature and a distortion of a diffraction pattern plane to reproduce a real image.

For the field curvature correction of a diffraction pattern plane, first a diffraction pattern of a sample having a known structure is used as the reference for a diffraction pattern of an observation sample. Then, a camera length is determined by using a diffraction spot spacing and a diffraction angle of a diffraction pattern of a sample having a known structure, and the camera length is substituted into a correction function for the field curvature of a diffraction pattern plane. For the diffraction pattern of the observation sample, a correction value at each pixel is derived from the correction function and the field curvature of the diffraction pattern plane is corrected. It is noted that for the correction of the field curvature of a diffraction pattern plane, a camera length which is determined by another method may be used. By doing so, it is possible to capture a more accurate diffraction pattern in which the amount of computation is low and there is no field curvature of the diffraction pattern plane.

Moreover, for the correction of distortion, a sample having a known structure is used, as in the case of the correction of field curvature of diffraction pattern plane. In an experimentally obtained diffraction spot position, distortion that is dependent on an off-axis distance from the optical axis, and a distortion that occurs due to the effect of external environment are present. Then, an equation of distortion amount is assumed for a diffraction pattern derived from structure. A fitting is performed such that the distortion amount becomes close to that of an experimentally obtained diffraction pattern, with distortion coefficients and a deformation center being variables. Thereby, a deformation center and distortion coefficients are determined. This makes it possible to capture a diffraction pattern without distortion with relative ease.

It is noted that the distortion amount can be determined by another method. In this case, a diffraction pattern of a sample having a known structure is obtained, and since the diffraction pattern without distortion is known from the structure, the amount of distortion is determined as a two-dimensional distortion map. Thereby, the amount of distortion in a two-dimensional diffraction pattern is determined.

Then, to obtain a diffraction pattern with the correction of distortion for any sample, the above described distortion coefficients, deformation center, and two-dimensional distortion map are measured and the condition of the electro-optic system is recorded to capture a diffraction pattern of a sample at the same observation condition and perform correction. Thereby, a diffraction pattern without distortion can be captured.

Then, hidden phase information is derived from the diffraction pattern without distortion to reconstruct a real image (diffraction imaging technique). A diffraction pattern (inverse space) and a real image (real space) are in the relationship of a Fourier transform/inverse Fourier transform, and therefore it is possible that with any phase information given in the inverse space, an inverse Fourier transformation is performed to construct a real space, and a Fourier transformation is performed again returning to the inverse space. By repeating this calculation, accurate phase information can be reconstructed. Once the phase information can be reconstructed, it becomes possible to find what is intrinsically invisible in a real space, for example, factors which disturb the phase of wave.

**Claims**

1. A method for capturing a diffraction pattern of a sample by radiating a charged particle beam onto the sample, and detecting a charged particle beam occurring from the sample, comprising the steps of:

   capturing a diffraction pattern of a first sample at a predetermined experimental condition and measuring a distortion of the diffraction pattern in the first sample;
   calculating a correction parameter for correcting the distortion of the diffraction pattern in the first sample,
   capturing a diffraction pattern of a second sample at the predetermined measurement condition; and
   correcting a distortion of the diffraction pattern of the second sample by using the correction parameter relating to the first sample.

2. The method for capturing a diffraction pattern according to claim 1, wherein
   the first sample is a sample having a known structure.

3. The method for capturing a diffraction pattern according to claim 1 or 2, wherein
   the distortion of the diffraction pattern includes field curvature of the diffraction pattern, and
   the step of calculating the correction parameter is configured such that a parameter for correcting field curvature of the diffraction pattern is calculated based on a diffraction angle and a camera length that is defined by a distance between the first sample and a detection plane of the diffraction pattern of the first sample.

4. The method for capturing a diffraction pattern according to any one of claims 1 to 3, wherein
   the distortion of the diffraction pattern includes a distortion aberration, and
   the step of calculating the correction parameter comprises the steps of:

   determining a difference between a diffraction pattern obtained from a structure of the first sample and a diffraction pattern in which a distortion coefficient is taken into consideration;
   performing a fitting of the distortion coefficients to minimize the difference; and
   calculating a distortion amount by using the distortion coefficient obtained by performing the fitting as a correction amount for correcting the distortion aberration, and

   wherein
   a correction amount for correcting the distortion coefficient and the distortion aberration is taken as the correction parameter.

5. The method for capturing a diffraction pattern according to any one of claims 1 to 3, wherein
   the distortion of the diffraction pattern is a distortion aberration, and
   the step of calculating the correction parameter is configured such that a distortion vector between a diffraction pattern obtained from the structure of the first sample and a distorted diffraction pattern of the first sample is calculated and the distortion vector is taken as the correction parameter.

6. A charged particle beam device for capturing a diffraction pattern of a sample by radiating a charged particle beam onto a sample and detecting a charged particle beam occurring from the sample, comprising:

   a charged particle source which generates a charged particle beam;
   a detector which detects a charged particle beam occurring from the sample by radiating the charged particle beam onto a sample;
   a distortion measurement section which captures a diffraction pattern of a first sample at a predetermined measurement condition and measures the distortion of a diffraction pattern in the first sample;
   a parameter calculation section which calculates a correction parameter for correcting a distortion of a diffraction pattern in the first sample; and
   a distortion correction section which corrects a distortion of a diffraction pattern by using the correction parameter, wherein

the distortion measurement section captures a diffraction pattern of a second sample at the predetermined measurement condition and measures a distortion of the diffraction pattern in the second sample, and the distortion correction section corrects the distortion of the diffraction pattern of the second sample by using the correction parameter relating to the first sample.

7. The charged particle beam device according to claim 6, wherein the first sample is a sample having a known structure.

8. The charged particle beam device according to claim 6 or 7, wherein the distortion of the diffraction pattern includes field curvature of the diffraction pattern, and the parameter calculation section is configured to calculate a parameter for correcting field curvature of the image plane based on a diffraction angle and a camera length that is defined by a distance between the first sample and a detection plane of the diffraction pattern of the first sample.

9. The charged particle beam device according to claims 6 to 8, wherein the distortion of the diffraction pattern includes a distortion aberration, and the step of calculating the correction parameter comprises the steps of:

determining a difference between a diffraction pattern obtained from a structure of the first sample and a diffraction pattern in which a distortion coefficient is taken into consideration;
performing a fitting of the distortion coefficients to minimize the difference; and
calculating a distortion amount by using the distortion coefficient obtained by performing the fitting as a correction, amount for correcting the distortion aberration, and wherein
a correction amount for correcting the distortion coefficient and the distortion aberration is taken as the correction parameter.

10. The charged particle beam device according to claim 6 to 8, wherein the distortion of the diffraction pattern is a distortion aberration, and the parameter calculation section is configured to calculate a distortion vector between a diffraction pattern obtained from the structure of the first sample and a distorted diffraction pattern of the first sample and take the distortion vector as the correction parameter.

# FIG. 1

# FIG. 2

Diffraction observation by known specimen — S1

Diffraction spot detection — S2

Camera-length calculation from the diffraction- spot spacing and correction-function generation — S3

Coordinate transformation for field curvature — S4

Fitting distortion center and coefficient of distortion from ideal model — S5

Distortion correction for all pixels — S6

Saving transformation table — S7

Specimen exchange — S8

Diffraction pattern recording for unknown specimen — S9

Correction by transformation table — S10

# FIG. 3

# FIG. 4

# FIG. 5

A    With distortion aberration          B    Without distortion aberration

# FIG. 6

# FIG. 7

# FIG. 8

A    Measurement an amount of distortion          B    Making a distortion map

# FIG. 9

Before correction — 110
After correction — 111

Camera length | Spot coordinates | Error
--- | --- | ---
L = | (x,y) = ( , ) | $\delta_{(x,y)}=$

112 113 116

Lens current value

Condenser lens 1 ......... A
Condenser lens 2 ......... A
Deflector for axis alignment ......... A
Stigma correction lens ......... A
Deflector for image shift ......... A
Objective lens ......... A
Intermediate lens ......... A
Projector lens ......... A

Stage coordinates — 101

X Y Z

Correction | Save

115 100

EP 2 261 947 A1

# FIG. 10

| | Before correction | | After correction | | |
|---|---|---|---|---|---|

EP 2 261 947 A1

Lens current value

Condenser lens 1 [ ] A
Condenser lens 2 [ ] A
Deflector for axis alignment [ ] A
Stigma correction lens [ ] A
Deflector for image shift [ ] A
Objective lens [ ] A
Intermediate lens [ ] A
Projector lens [ ] A

Stage coordinates

| X | Y | Z |
|---|---|---|
| [ ] | [ ] | [ ] |

Save

| Distortion coefficient | Distortion center coordinate | Magnification rotation angle | Error |
|---|---|---|---|
| C3= C2=<br>C1= C0= | (x, y) = ( , ) | M=<br>R= | δ = |

# FIG. 11

**Observing image** (141)

- Micromotion of corresponding spot (X) | 50.2 | pix.
- Micromotion of corresponding spot (Y) | 43.2 | pix.
- Micromotion of corresponding spot (Z) | 5.2 | deg.

(143, 144, 145)

**Distortion map** (142, 140)

Correction function — Linear (146)

**Lens current value** (147)

| | |
|---|---|
| Condenser lens 1 | A |
| Condenser lens 2 | A |
| Deflector for axis alignment | A |
| Stigma correction lens | A |
| Deflector for image shift | A |
| Objective lens | A |
| Intermediate lens | A |
| Projector lens | A |

**Stage coordinates** (148)

| X | Y | Z |
|---|---|---|
| | | |

**Save** (149)

EP 2 261 947 A1

# FIG. 12

151

152

153

Before correction

After correction

Distortion file name

▽

Calculation — 154

Save — 155

150

## INTERNATIONAL SEARCH REPORT

| | International application No. |
|---|---|
| | PCT/JP2009/056960 |

A.  CLASSIFICATION OF SUBJECT MATTER
*H01J37/22*(2006.01)i, *H01J37/26*(2006.01)i, *H01J37/295*(2006.01)i

According to International Patent Classification (IPC) or to both national classification and IPC

B.  FIELDS SEARCHED

Minimum documentation searched (classification system followed by classification symbols)
H01J37/22, H01J37/26, H01J37/295

Documentation searched other than minimum documentation to the extent that such documents are included in the fields searched
Jitsuyo Shinan Koho          1922-1996   Jitsuyo Shinan Toroku Koho    1996-2009
Kokai Jitsuyo Shinan Koho    1971-2009   Toroku Jitsuyo Shinan Koho    1994-2009

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X | JP 2008-14850 A  (Hitachi High-technologies Corp.), 24 January, 2008 (24.01.08), Par. Nos. [0010] to [0015], [0019] to [0021], [0025], [0028] to [0031], [0041] to [0043]; Figs. 1, 2, 5, 8, 13 & US 2008/0093551 A1 | 1-2,6-7 |
| A | JP 2007-109509 A  (Fujitsu Ltd.), 26 April, 2007 (26.04.07), Par. Nos. [0017] to [0028], [0037] to [0049]; Figs. 1, 9, 10 (Family: none) | 1-2,6-7 |

|  ☒  Further documents are listed in the continuation of Box C. | ☐  See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 26 June, 2009 (26.06.09) | 07 July, 2009 (07.07.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.

PCT/JP2009/056960

C (Continuation). DOCUMENTS CONSIDERED TO BE RELEVANT

| Category* | Citation of document, with indication, where appropriate, of the relevant passages | Relevant to claim No. |
|---|---|---|
| A | JP 2002-367551 A (Hitachi, Ltd.),<br>20 December, 2002 (20.12.02),<br>Par. Nos. [0016] to [0033], [0037] to [0055];<br>Figs. 1, 4<br>(Family: none) | 1-2,6-7 |
| A | JP 10-247468 A (Hitachi, Ltd.),<br>14 September, 1998 (14.09.98),<br>Par. Nos. [0001], [0009] to [0010], [0037]<br>to [0040]<br>(Family: none) | 3,8 |
| A | JP 61-110953 A (Hitachi, Ltd.),<br>29 May, 1986 (29.05.86),<br>Full text<br>(Family: none) | 3,8 |
| A | WO 2005/114693 A1 (National University<br>Corporation Hokkaido University),<br>01 December, 2005 (01.12.05),<br>Full text<br>& US 2008/0197281 A1 & EP 1768161 A1 | 1-10 |
| P,A | JP 2008-82927 A (Fujitsu Ltd.),<br>10 April, 2008 (10.04.08),<br>Full text<br>(Family: none) | 1-10 |
| P,A | JP 2008-171756 A (JEOL Ltd.),<br>24 July, 2008 (24.07.08),<br>Full text<br>(Family: none) | 1-10 |
| P,A | JP 2009-21156 A (Hitachi, Ltd.),<br>29 January, 2009 (29.01.09),<br>Full text<br>& US 2009/0014651 A1 & EP 2015342 A2 | 1-10 |

Form PCT/ISA/210 (continuation of second sheet) (April 2007)

## INTERNATIONAL SEARCH REPORT

| International application No. |
| --- |
| PCT/JP2009/056960 |

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:
   See the extra sheet.

1. ☒ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.    Consequently, this international search report is restricted to the invention first mentioned in the claims; it is covered by claims Nos.:

**Remark on Protest**
the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☒ No protest accompanied the payment of additional search fees.

Form PCT/ISA/210 (continuation of first sheet (2)) (April 2007)

**INTERNATIONAL SEARCH REPORT**

International application No.

PCT/JP2009/056960

Continuation of Box No.III of continuation of first sheet(2)

For the reasons below, the present application contains two inventions not satisfying the requirement of unity of invention.

Main Invention: Claims 1-2, 6-7
Second Invention: Claims 3-5, 8-10

The matter common to the inventions of claims 1-5 is the one stated in claim 1. The matter common to the inventions of claims 6-10 is a device specially designed for using the method defined in claim 1.

However, the international search has revealed that the common matters are not novel since they are disclosed in document 1.

Document 1: JP 2008-14850 A (Hitachi High-technologies Corp.), 24 January, 2008 (24.01.08), paragraphs 0010 to 0015, 0019 to 0021, 0025, 0028 to 0031, figures 1, 2, 5, 8
& US 2008/0093551 A1

In consequence, the common matters make no contribution over the prior art, they are not special technical features within the meaning of PCT Rule 13.2, second sentence.
Therefore, there is no special technical feature common to all the inventions of claims 1-10.

Consequently, the inventions of claims 1-10 obviously do not comply with the requirement of unity of invention.

Form PCT/ISA/210 (extra sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005114693 A1